(19) Europäisches Patentamt

European Patent Office

Office européen des brevets

(11) **EP 1 054 076 A2**

(12) **EUROPEAN PATENT APPLICATION**

(43) Date of publication:
22.11.2000 Bulletin 2000/47

(51) Int. Cl.[7]: **C23C 16/44**, C23C 16/455

(21) Application number: 00304070.6

(22) Date of filing: 15.05.2000

(84) Designated Contracting States:
**AT BE CH CY DE DK ES FI FR GB GR IE IT LI LU
MC NL PT SE**
Designated Extension States:
**AL LT LV MK RO SI**

(30) Priority: **17.05.1999 US 134443 P
31.01.2000 US 494620**

(71) Applicant:
**Silicon Valley Group Thermal Systems LLC
Scotts Valley, CA 95066 (US)**

(72) Inventors:
• **Bartholomew, Lawrence D.
Felton, CA 95018 (US)**
• **Yuh, Soon K.
Scotts Valley, CA 95066 (US)**
• **Stumbo, Gregory M.
Scotts Valley, CA 95066 (US)**
• **King, Mark B.
Scotts Valley, CA 95066 (US)**
• **Chan, Jeffrey
San Jose, CA 95131 (US)**

(74) Representative:
**Allard, Susan Joyce et al
BOULT WADE TENNANT,
Verulam Gardens
70 Gray's Inn Road
London WC1X 8BT (GB)**

(54) **Gas distribution system**

(57)     The present invention provides an apparatus and method for distributing gas to multiple feeds into a chamber 125 to process a substrate 115. In one embodiment, the system 155 includes a process gas injector 190 for introducing process gas into the chamber 125 and a shield assembly 200 having a number of shield bodies 210, 215, adjacent to the process gas injector to reduce deposition of process byproducts thereon. Each shield body 210, 215, has a screen 230 and a metering tube 240 with an array of holes 245 therein to deliver shield gas through the screen. Shield gas is supplied to the metering tubes 240 through a number of flowpaths 255, each having a flow limiter 265 with an orifice 270 sized so that equal flows of shield gas are provided from each of the shield bodies 210, 215. Preferably, the orifices 270 are also sized so that the flow of shield gas through each metering tube 240 is constant, even if the shield gas is supplied from a supply that varies in pressure or flow.

FIG. 3

## Description

This application claims priority from United States Provisional Patent Application Serial Number 60/134,443 filed May 17, 1999, which is incorporated herein by reference.

The present invention relates generally to chemical vapor deposition systems and more particularly to an improved gas distribution system for providing gas at substantially equal flow rates to multiple paths within chemical vapor deposition systems.

Chemical vapor deposition (CVD) systems are well known and widely used to deposit or grow thin films of various compositions upon surfaces of substrates. For example, CVD systems are commonly used to deposit dielectric, passivation and dopant layers upon semiconductor wafers. CVD systems operate by introducing a reactive process gas or chemical vapor into a deposition chamber in which the substrate to be processed has been placed. As the vaporized material passes over the substrate it is adsorbed and reacts on the surface of the substrate to form the film. Various inert carrier gases may also be used to carry a solid or liquid source into the deposition chamber in a vapor form. Typically, the substrate is heated to catalyze the reaction.

One type of CVD system that is widely used in processing semiconductor wafers is an atmospheric pressure chemical vapor deposition system (hereinafter APCVD system). APCVD systems are described in, for example, U.S. Pat. No. 4,834,020, to Bartholomew et al., which is incorporated herein by reference. In an APCVD system, the deposition chamber is operated at atmospheric pressure while gaseous source chemicals are introduced to react and deposit a film on the substrate. One kind of APCVD system uses a belt or conveyor to move the substrates through a series of deposition chambers during the deposition process. A typical belt-driven APCVD may have from four to six separate deposition chambers. Each chamber has a linear process gas injector for introducing process gas into the chamber to process the substrates, and one or more exhaust ports for exhausting gases and byproducts from the chamber.

Linear process gas injectors are described, for example, in U.S. Pat. No. 5,683,516, to DeDontney et al., which is incorporated herein by reference. Typically, the injector has several injection ports positioned less than one inch from a surface of the substrate, and often as close as $\frac{1}{8}$ to $\frac{1}{2}$ inches. With this limited clearance between the injection ports and the substrate surface, the injection ports can soon become coated with material and byproducts produced during the deposition process. Material and byproducts can also be deposited on lower edges of the exhaust ports. Over time, these deposits accumulate becoming a source of particles that become embedded in the film deposited on the substrate degrading film quality. Thus, this accumulation must be slowed or prevented.

Several approaches have been tried to reduce the accumulation of deposits on the injection ports and the exhaust ports of the CVD system. One approach uses a number of shields adjacent to and surrounding the injector and lower surfaces of the exhaust ports. Shields are described, for example, in U.S. Pat. No. 5,849,088, to DeDontney et al., and U.S. Pat. No. 5,944,900, to Tran, which are incorporated herein by reference. Each shield typically includes a base or support body joined to a screen to form a plenum into which an inert shield gas, such as nitrogen, is introduced. The shield gas is delivered to the plenum through a conduit or metering tube having an array of holes along its length. A number of delivery lines provide shield gas to the metering tube from a gas manifold or bulkhead fitting in the APCVD system. The gas manifold in turn is connected to an external shield gas supply that is typically remotely located. The inert gas diffuses through the screens to displace and dilute the reactive process gases in the region adjacent to the shields, thereby reducing deposition on the shield itself.

Creation of films on substrates that are typically 200 mm in diameter with decreasing non uniformities below 3% becomes increasingly dependent on having well-controlled and well-defined gas flow balance in and around the process gas injection regime. The shields typically flank the linear process gas injector, while the substrate moves beneath the assembly in a fixed direction. With requirements for film non uniformities of less than 3%, it is vital that the shield gas flow flanking the process gas remain stable over time, and that gas flow on each side of the injector be well-defined along its own length and be well-defined with respect to the gas flow on the side opposite. Thus, there is a need for an apparatus and method that can provide a well-defined and well-controlled flow of shield gas so as not to disrupt the process gas flow.

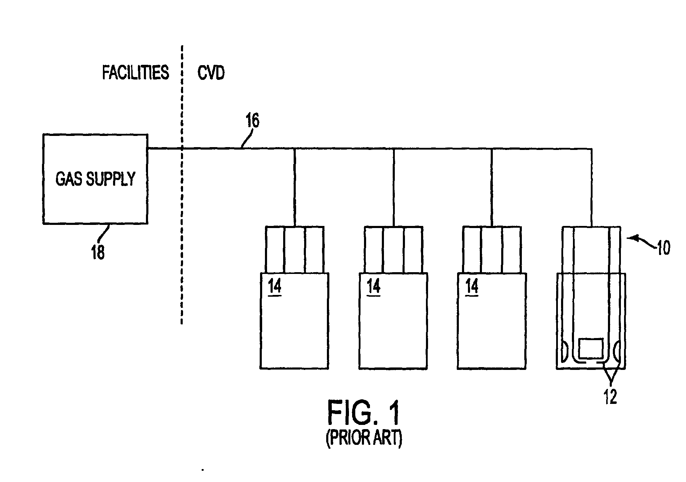

The flow of shield gas from a given shield is dependent on the number and size of the holes in the associated metering tube, and on the pressure and the volumetric flow rate at which the shield gas is provided to the tube. The last two factors depend, in part, on the length and diameter of the delivery line that connects the metering tube in the shield to the shield gas supply. As shown in FIG. 1, the lengths of these delivery lines 10 typically vary from shield 12 to shield and from one deposition chamber 14 to the next. These variations are a consequence of physical limitations of the APCVD system, i.e., shields in deposition chambers farther from the gas manifold 16 or gas supply 18 necessarily require a longer delivery line 10, and of manufacturing imperfections in either the length or diameter of the delivery lines. These variations make it difficult to create a stable, well-defined and well-controlled flow from each metering tube (not shown) or shield 12.

Another problem with the above design is that fluctuations in flow or pressure of shield gas from the shield gas supply can cause unstable and unbalanced flows from the metering tubes, disrupting the process gas flow and causing non uniformities in film thickness. Thus, there is a need for an apparatus and method that can provide a flow of shield gas sufficiently high to reduce the accumulation of deposits on the shields, and sufficiently balanced and stable to ensure uniform processing within a single deposition chamber, and sufficiently balanced and stable across multiple chambers to ensure equivalent process results from each chamber.

A conventional approach to solving the above problems is to connect each metering tube in a shield to the shield gas supply through separate lines each with an independent pressure regulator or mass flow controller. A fundamental problem with this approach is the increased costs associated with purchasing, installing and maintaining as many as sixteen pressure regulators or mass flow controllers for a single APCVD system having four chambers each having four shields. Moreover, this approach does not solve the problem of maintaining a shield gas flow from each shield balanced in relation to the other shields. In fact, having multiple pressure regulators or mass flow controllers can complicate the solution because all must be kept in calibration with respect to each other, or otherwise cause an unbalanced shield gas flow. Finally, for simplicity and to enable ease of maintenance, principles of good design dictate that for a given gas, a single line is preferred to connect the APCVD system to the gas supply.

Accordingly, there is a need for an apparatus and method that delivers a flow of shield gas to shields surrounding injection ports and exhaust ports of a chamber in an APCVD system sufficiently high to reduce the formation and accumulation of deposit thereon. There is also a need for an apparatus and method that provides a flow of shield gas that is sufficiently stable and balanced to allow a well-controlled and well-defined process gas flow around a substrate in the chamber. There is a still further need for an apparatus and method that provides a flow of shield gas that is sufficiently stable and balanced to ensure uniform processing results from multiple chambers within the system. There is a still further need for an apparatus and method that reduces variations in shield gas flow due to fluctuations in flow or pressure from a shield gas supply without the use of numerous, independent pressure regulators or mass flow controllers.

An object of the present invention is to provide a system and method for introducing gas into a chamber of a chemical vapor deposition (CVD) system. More specifically, the present invention provides an improved gas distribution system for introducing shield gas into the chamber through multiple paths at substantially constant and equal flow rates.

According to one embodiment, the gas distribution system includes a process gas injector for introducing process gas into the chamber, and a shield assembly having a number of shield bodies adjacent to the process gas injector to reduce deposition of process byproducts thereon. Each shield body has a screen and a conduit with an array of holes therein to deliver shield gas through the screen. The shield gas can be either an inert gas and a diluent gas, and is supplied to the vents trough a number of flowpaths, at least one flowpath coupled to each conduit to supply shield gas thereto. Each of the flowpaths includes a flow limiter having an orifice with a cross-sectional area ($A_{orifice}$) sized so that substantially equal flows of shield gas are provided from each of the shield bodies. The flow limiter can be in delivery lines coupled to inlets of the conduits or in the conduits themselves. Preferably, the orifices are also sized so that the flow of shield gas through each conduit is constant, even if the shield gas is supplied from a single shield gas supply that varies in pressure or flow.

Generally, the holes in each conduit comprise a total cross-sectional area that is substantially equal to that of other conduits. Thus, providing equal flows of shield gas from each of the shield bodies is accomplished by sizing orifices to provide substantially equal back pressure at the inlet to each of the conduits, and a constant flow is accomplished by providing a back pressure sufficiently high to allow for variations in pressure or flow from the supply. To provide a sufficient back pressure when the holes in each conduit comprise a total cross-sectional area ($A_{holes}$) and the flowpath associated with the conduit comprises a cross-sectional area ($A_{flowpath}$), the cross-sectional area of the orifice ($A_{orifice}$) in the flow limiter in the flowpath should be less than total cross-sectional area of the holes, and the total cross-sectional area of the holes should be less than the cross-sectional area of the flowpath. ($A_{orifice} < A_{holes} < A_{flowpath}$). Preferably, the sum of the cross-sectional areas of all the orifices in the flow limiters in all of the flowpaths (Total $A_{orifice}$) is less than a sum of the cross-sectional areas of the holes in all of the conduits (Total $A_{holes}$), and the sum of the cross-sectional areas of the holes in all of the conduits is less than a sum of the cross-sectional areas of all of the flowpaths (Total $A_{flowpaths}$). (Total $A_{orifice}$ < Total $A_{holes}$ < Total $A_{flowpath}$). More preferably, Total $A_{holes}$/Total $A_{orifice} \geq 1.5$, and Total $A_{flowpath}$/Total $A_{holes} \geq 1$.

In another aspect, the present invention is directed to a method of operating a chemical vapor deposition system to process a substrate. In the process, a shield assembly including a number of shield bodies is provided adjacent to a process gas injector to reduce deposition of process byproducts thereon. Each shield body has a screen and a conduit with an array of holes therein capable of delivering shield gas through the screen to reduce deposition of process byproducts on the screen. Shield gas is supplied to the conduits through a number of flowpaths, and the flow of shield gas through the flowpaths is limited by providing in each flowpath a flow limiter having an orifice therein. The orifice has a cross-sectional area ($A_{orifice}$) sized so that substantially equal flows of shield gas are provided from each of the shield bodies. The substrate is placed in a chamber, and process gas introduced into the chamber to process the substrate through a process gas injector. In one preferred embodiment, the holes in each conduit comprise a total cross-sectional areas ($A_{holes}$) that is substantially equal to that of other conduits, and an equal flow of shield gas is achieved by providing a flow limiter having an orifice sized to yield equal back pressure at an inlet to each of the conduits.

In yet another aspect, the present invention is directed to a CVD system for processing a substrate, the system having a means for providing an equal flow of shield gas from each of several shield bodies of a shield assembly. Typically, the system also includes a chamber in which the substrate is processed, and a process gas injector for introducing process gas into the chamber. The shield bodies are next to the process gas injector to reduce deposition of process byproducts thereon. Each shield body has a screen and a conduit with an array of holes therein to deliver shield gas through the screen to reduce deposition on the screen. Several flowpaths supply shield gas to the conduits. At least one flowpath is coupled to each conduit. An exhaust system having at least one exhaust port in the chamber to exhausts gases and byproducts from the chamber. In one embodiment, the means for providing an equal flow of shield gas from each conduit includes a flow limiter in each flowpath, the flow limiter having an orifice sized to provide equal flows of shield gas.

These and various other features and advantages of the present invention will be apparent upon reading of the following detailed description in conjunction with the accompanying drawings, provided by way of example:

FIG. 1 (prior art) is a schematic diagram showing delivery lines for delivering gas to multiple shields in multiple chambers of a conventional chemical vapor deposition (CVD) system;

FIG. 2 is a schematic side view of a belt-driven atmospheric pressure chemical vapor deposition (APCVD) system;

Fig. 3 is a partial side view of an APCVD system showing a chamber having an embodiment of a gas distribution system according to the present invention;

Fig. 4 is a partial side view of an APCVD system showing a chamber having another embodiment of a gas distribution system according to the present invention; and

FIG. 5 is a is a flowchart showing an embodiment of a process for operating an APCVD system to provide a substantially equal flow of shield gas to a number of delivery tubes according to an embodiment of the present invention.

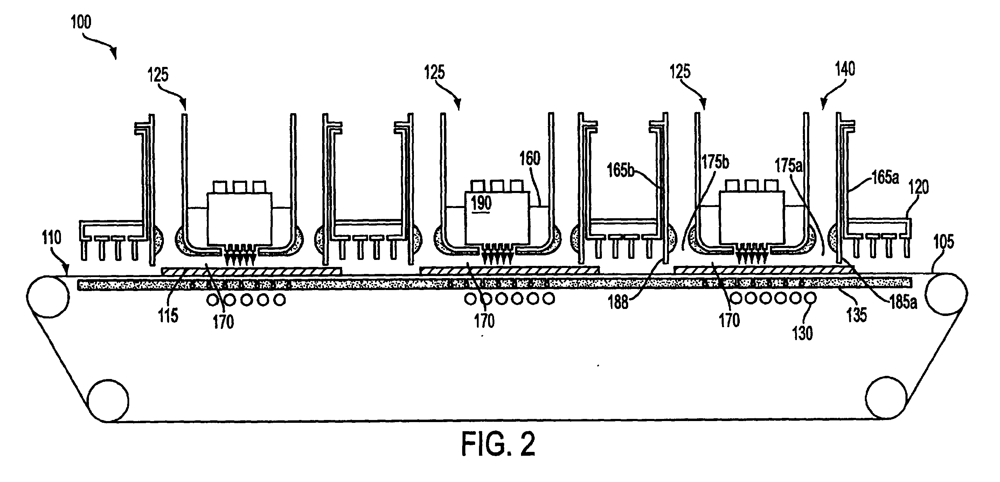

The present invention provides an apparatus and method for distributing gas to multiple feeds into a chamber to process a substrate. The apparatus and method according to the present invention are particularly useful to ensure high quality film deposition on semiconductor wafers using an atmospheric chemical vapor deposition system (APCVD system), such as shown in FIG. 2. The embodiment of the APCVD system shown herein is provided only to illustrate the invention and should not be used to limit the scope of the invention.

Referring to FIG. 2, a typical APCVD system 100 generally includes an endless wire belt 105 with a surface 110 for moving a substrate 115 through a process muffle 120 having one or more chambers 125 into which a process gas or chemical vapor is introduced to process the substrate. Heating elements 130 below a floor 135 of the process muffle 120 heat the substrates 115 to from about 200 to about 750°C. An exhaust system 140 exhausts spent chemical vapors, gases and process byproducts from the process muffle 120 and the chambers 125.

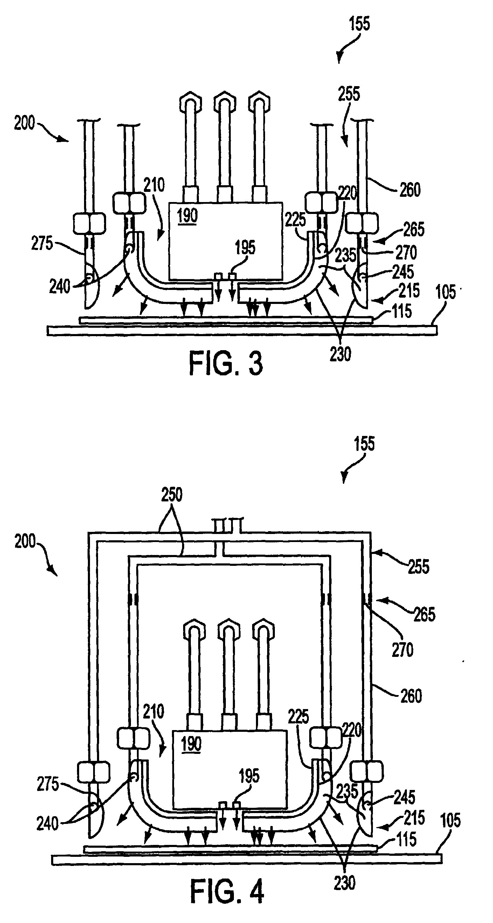

FIG. 3 is a partial side view of a chamber 125 of the APCVD system 100 having an embodiment of a gas distribution system 155 according to the present invention. The chamber 125 includes a top wall 160 and sidewalls 165a, 165b, enclosing and defining a process zone 170 in which a film or layer (not shown), such as a dielectric, semiconducting or passivation layer, is deposited on the substrate 115. The gas distribution system 155 distributes chemical gases in the chamber 125 to process the substrate 115. One or more exhaust ports 175a, 175b, defined by lower edges 185a, 185b, of the sidewalls 165a, 165b, and the surface 110 of the belt 105, remove spent chemical vapors and gases from the chamber 125. Together, the gas distribution system 155 and the exhaust ports 175a, 175b, create a well-controlled and well-defined process gas flow around the substrate 115.

The gas distribution system 155 includes a linear process gas injector 190 having one or more injection ports 195 for introducing reactant process gases into the chamber 125. The gas distribution system 155 also has a shield assembly 200 having a number of injector shield bodies 210 adjacent to the process gas injector 190 and vent shield bodies 215 adjacent to the exhaust ports 175a, 175b, to reduce deposition of process byproducts thereon. Shield assemblies are described in, for example, U.S. Pat. No. 5,944,900, to Tran, U.S. Pat. No. 5,849,088, to DeDontney et al., and in U.S. Provisional Pat. Application No. 60/135362, all of which are incorporated herein by reference. Each shield body 210,215, generally consists of a base 220 attached to a frame 225 abutting the process gas injector 190 or the exhaust ports 175a, 175b, and a perforated sheet or screen 230 joined to the base to form a plenum 235 into which a diluent or inert shield gas, such as nitrogen, is introduced. The shield gas disperses or diffuses through the screen to reduce deposition thereon. The shield gas is introduced into the plenum 235 through a conduit or metering tube 240. In one embodiment, the metering tube consists of a single porous tube having an array of gas outputs or holes 245 equally space along the length thereof. In another embodiment (not shown), the metering tube 240 consists of two or more nested, coaxial tubes, as described in commonly assigned co-pending U.S. Pat. Application (Attorney docket No. A-67178). In this version, only the inner most tube is coupled to a gas supply, and both the inner and outer tubes have arrays of holes along their length to enhance the dispersion of the shield gas.

Shield gas is supplied to the plenums 235 of the shield bodies 210,215, from a bulkhead fitting or gas manifold 250 in the APCVD system 100 along a number of flowpaths 255. The gas manifold 250 in turn is connected to an external shield gas supply (not shown) that is typically located some distance from the APCVD system 100. The flowpath 255 includes both the metering tube 240 and a delivery line 260 coupled to the metering tube. In one embodiment (not shown), shield gas was supplied by two delivery lines 260 to both ends of the metering tube 240. In accordance with the present invention, each of the flowpaths 255 has at least one flow limiter 265 with an orifice 270 having a cross-sectional area ($A_{orifice}$) sized so that substantially equal flows of shield gas are provided from each of the plurality of metering tubes 240 and/or shield bodies 210,215. The flow limiters 265 can be in inlets 275 of the metering tubes 240, as shown in FIG. 3, or further up in the delivery lines 260, as shown in FIG. 4. Preferably, the flow limiters 265 are in the inlets 275 of the metering tubes 240, or in the delivery lines as close to the inlets as possible, to provide a substantially equal back pressure at the gas outputs 245. More important than the location of the flow limiters 265 in the flowpaths 255 is that the orifice 270 of the flow limiter in each flowpath be at substantially the same distance along the flowpath from the gas outputs 245. The orifice 270 can include a single large aperture (as shown), or several smaller apertures (not shown) wherein each aperture has a fixed size and the number of apertures is selected to provide the requisite total cross-sectional area.

To ensure a stable flow of shield gas is equally split between two or more flowpaths 255, the cross-sectional area of the orifice 270 in the flow limiter 265 of each flowpath is less than a total cross-sectional area ($A_{holes}$) in the metering tube 240, which in turn is less than a cross-sectional area of an inner diameter of the flowpath ($A_{flowpath}$). Thus,

$$A_{orifice} < A_{holes} < A_{flowpath}$$

A further advantage of this relative sizing of the cross-sectional area of the orifices 270 is that it reduces variations in shield gas flow due to fluctuations in flow or pressure from the shield gas supply. This is particularly important in the field of semiconductor manufacturing because even slight variation in shield gas flow can alter the process gas flow around the substrate 115 resulting in non-uniformities in film thickness. As explained above, in semiconductor manufacturing non-uniformities in film thickness typically must be kept to well less than 3% of a target thickness. Preferably, the sum of the cross-sectional areas of all the orifices 170 in the flow limiters 165 in all of the flowpaths 255 (Total $A_{orifice}$) is less than a sum of the cross-sectional areas of the holes 245 in all of the metering tubes 240 (Total $A_{holes}$), and the sum of the cross-sectional areas of the holes 245 in all of the metering tubes is less than a sum of the cross-sectional areas of all of the flowpaths (Total $A_{flowpaths}$). Thus,

$$\text{Total } A_{orifice} < \text{Total } A_{holes} < \text{Total } A_{flowpath}$$

More preferably, the ratio of the sum of the cross-sectional areas of the holes 245 in all of the metering tubes 240 to the sum of the cross-sectional areas of all the orifices 170 is greater than or equal to about 1.5, and the ratio of the sum of the cross-sectional areas of all of the flowpaths 255 to the sum of the cross-sectional areas of the holes 245 in all of the metering tubes is greater than or equal to about 1. Thus,

$$\text{Total } A_{holes} / \text{Total } A_{orifice} \geq 1.5$$

and

$$\text{Total } A_{flowpath} / \text{Total } A_{holes} \geq 1$$

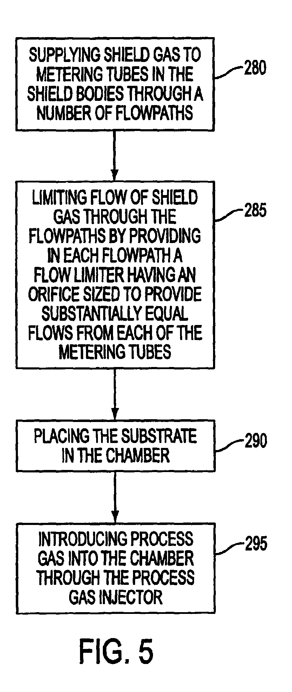

A method of operating an APCVD system 100 to deposit a layer on a substrate 115 will now be described with reference to FIG. 5. In the method, shield gas is supplied to the metering tubes 240 through a number of flowpaths 255 (step 280), and the flow of shield gas through the flowpaths 255 limited by providing in each flowpath a flow limiter 265 having an orifice 270 therein (step 285). The substrate 115 is placed in the chamber (step 290), and process gas introduced into the chamber through injection ports 195 of a process gas injector 190 to process the substrate (step 290).

In one preferred embodiment of the method, the holes 245 in each metering tube 240 have a total cross-sectional area ($A_{holes}$), and the step of supplying shield gas to the metering tubes (step 280) includes the step of supplying shield gas through flowpaths having a cross-sectional area ($A_{flowpath}$) sized so that $A_{holes} < A_{flowpath}$. More preferably, the step of limiting the flow of shield gas (step 285) includes the step of providing flow limiters having an orifice with a cross-sectional area ($A_{orifice}$) sized so that $A_{orifice} < A_{holes} < A_{flowpath}$.

## EXAMPLE

The following example is provided to illustrate advantages of certain embodiments of the present invention, and are not intended to limit the scope of the invention in any way.

An APCVD system 100, such as a WJ-1500 commercially available from Silicon Valley Group, Thermal Systems, LLC, of Scotts Valley California, was provided with a gas distribution system according to the present invention. The gas distribution system in each chamber included a shield assembly having a pair of injector shield bodies adjacent to a process injector, and a pair of vent shield bodies adjacent to two exhaust ports. Each of the shield bodies included a metering tube consisting of two nested, coaxial tubes (not shown). Each of the inner tubes included thirty-nine holes spaced apart equally along their length and around their circumference, each hole has a diameter of 0.01 inches for a total cross-sectional area ($A_{holes}$) of about 0.0031 $in^2$. The outer tubes have an array of holes that distribute the shield gas in the plenums of the shield bodies. Shield gas was supplied to the metering tubes through flowpaths having a minimum internal diameter of 0.114 inches for a cross-sectional area ($A_{flowpath}$) of about 0.0102 $in^2$. In a test setup, the flowpaths supplying shield gas to each of the shield bodies were not connected to a single manifold but rather were connected individually to shield gas supplies so that the backing pressure to each could be varied individually to purposely create an imbalance. In this test example, to ensure substantially equal flows from each of the shield bodies flow limiters having orifices with diameters of 0.047 inches and a cross-sectional area ($A_{orifice}$) of about 0.0017 $in^2$ were used. To evaluate the effectiveness of the flow limiters in correcting or compensating for an imbalance one of the two injector shield bodies was supplied with shield gas at a backing pressure of 67.4 inches of water, and the other injector shield body was supplied at 37.8 inches of water. The vent shield bodies were held constant at a backing pressure of about 37 inches of water. In subsequent tests the APCVD system with the gas distribution system described above was used to deposit films having thicknesses of from 1750 Å to 1836 Å on semiconductor substrates. A films had non uniformities of less than 2.77%. A subsequent test using a standard gas distribution system without the flow limiters and with the same skewed backing pressure resulted in a non uniformity of 10.8% for a 1262 Å film. Thus, the test illustrated the ability of a gas distribution system according to the present invention to compensate for even a gross imbalance in pressure upstream from the orifices.

It is to be understood that even though numerous characteristics and advantages of certain embodiments of the present invention have been set forth in the foregoing description, together with details of the structure and function of various embodiments of the invention, this disclosure is illustrative only, and changes may be made in detail, especially in matters of structure and arrangement of parts within the principles of the present invention to the full extent indicated by the broad general meaning of the terms in which the appended claims are expressed.

## Claims

1. A shield assembly for a chemical vapor deposition system, the shield assembly comprising:

   (a) a plurality of shield bodies, each shield body having a screen and a conduit with an array of holes therein to deliver shield gas through the screen; and
   (b) a plurality of flowpaths, at least one flowpath coupled to each conduit to supply shield gas thereto; and
   (c) a flow limiter in each of the plurality of flowpaths, the flow limiter having an orifice with a cross-sectional area ($A_{orifice}$) sized so that substantially equal flows of shield gas are provided from each of the plurality of shield bodies.

2. A shield assembly according to claim 1 wherein the plurality of flowpaths supply shield gas to the conduits from a single shield gas supply, and wherein the orifices are sized to provide a substantially constant flow of shield gas from each of the plurality of shield bodies even with variations in pressure or flow of shield gas from the shield gas supply.

3. A shield assembly according to claim 1 wherein the holes in each conduit comprise a total cross-sectional area ($A_{holes}$) and the flowpath associated with the conduit comprises a cross-sectional area ($A_{flowpath}$) and wherein $A_{orifice} < A_{holes} < A_{flowpath}$.

4. A shield assembly according to claim 1 wherein a sum of the cross-sectional areas of the orifices in the flow limiters in all of the flowpaths (Total $A_{orifice}$) is less than a sum of the cross-sectional areas of the holes in all of the conduits (Total $A_{holes}$), and wherein Total $A_{holes}$ is less than a sum of the cross-sectional areas of all of the flowpaths (Total $A_{flowpaths}$).

5. A gas distribution system for distributing gas in a chamber to process a substrate, the gas distribution system comprising:

   (a) a process gas injector capable of introducing process gas into the chamber;
   (b) a shield assembly having a plurality of shield bodies adjacent to the process gas injector to reduce deposition of process byproducts thereon, each shield body having a screen and a conduit with an array of holes therein to deliver shield gas through the screen;

(c) a plurality of flowpaths, at least one flowpath coupled to each conduit to supply shield gas thereto; and

(d) a flow limiter in each of the plurality of flowpaths, the flow limiter having an orifice with a cross-sectional area ($A_{orifice}$).

**6.** A chemical vapor deposition system for processing a substrate, the system comprising:

(a) a chamber in which the substrate is processed;

(b) a process gas injector capable of introducing process gas into the chamber to process the substrate;

(c) a shield assembly having a plurality of shield bodies adjacent to the process gas injector to reduce deposition of process byproducts thereon, each shield body having a screen and a conduit with an array of holes therein to deliver shield gas through the screen;

(d) a plurality of flowpaths, at least one flowpath coupled to each conduit to supply shield gas thereto; and

(e) means for providing a substantially equal flow of shield gas from each of the plurality of shield bodies; and

(f) an exhaust system having at least one exhaust port in the chamber to exhaust gases and byproducts therefrom.

**7.** A system according to claim 6 wherein the means for providing a substantially equal flow of shield gas from each of the conduits comprises a flow limiter in each of the plurality of flowpaths, the flow limiter having an orifice with a cross-sectional area ($A_{orifice}$) sized so that substantially equal flows of shield gas are provided from each of the plurality of shield bodies.

**8.** A system according to claims 5 or 7 wherein the holes in each conduit comprise a total cross-sectional area ($A_{holes}$) and the flowpath associated with the conduit comprises a cross-sectional area ($A_{flowpath}$) and wherein $A_{orifice} < A_{holes} < A_{flowpath}$.

**9.** A system according to claims 5 or 7 wherein a sum of the cross-sectional areas of the orifices in the flow limiters in all of the flowpaths (Total $A_{orifice}$) is less than a sum of the cross-sectional areas of the holes in all of the conduits (Total $A_{holes}$), and wherein Total $A_{holes}$ is less than a sum of the cross-sectional areas of all of the flowpaths (Total $A_{flowpaths}$).

**10.** A method of operating a chemical vapor deposition system to process a substrate, the method comprising steps of:

(a) providing a shield assembly comprising a plurality of shield bodies adjacent to a process gas injector to reduce deposition of process byproducts thereon, each shield body having a screen and a conduit with an array of holes therein capable of delivering shield gas through the screen to reduce deposition of process byproducts thereon;

(b) supplying shield gas to the conduits through a plurality of flowpaths;

(c) limiting flow of shield gas through the plurality of flowpaths by providing in each flowpath a flow limiter having an orifice therein, the orifice having a cross-sectional area ($A_{orifice}$) sized so that substantially equal flows of shield gas are provided from each of the plurality of shield bodies;

(d) placing the substrate in a chamber; and

(e) introducing process gas into the chamber trough the process gas injector to process the substrate.

**11.** A method according to claim 10 wherein the holes in each conduit comprise a total cross-sectional area ($A_{holes}$), and wherein step (b) comprises the step of supplying shield gas through flowpaths having a cross-sectional area ($A_{flowpath}$) sized so that $A_{holes} < A_{flowpath}$, and wherein step (c) comprises the step of providing flow limiters having an orifice sized so that $A_{orifice} < A_{holes} < A_{flowpath}$.

**12.** A method according to claim 11 wherein step (b) comprises the step of supplying shield gas through flowpaths having a total cross-sectional area such that Total $A_{flowpath}$/Total $A_{holes} \geq 1$, and wherein step (c) comprises the step of providing flow limiters having orifices sized so that Total $A_{orifice}$/Total $A_{holes} \geq 1.5$.

EP 1 054 076 A2

FACILITIES | CVD

16

GAS SUPPLY

18

14

14

14

10

12

FIG. 1
(PRIOR ART)

FIG. 2

FIG. 3

FIG. 4

SUPPLYING SHIELD GAS TO METERING TUBES IN THE SHIELD BODIES THROUGH A NUMBER OF FLOWPATHS — 280

LIMITING FLOW OF SHIELD GAS THROUGH THE FLOWPATHS BY PROVIDING IN EACH FLOWPATH A FLOW LIMITER HAVING AN ORIFICE SIZED TO PROVIDE SUBSTANTIALLY EQUAL FLOWS FROM EACH OF THE METERING TUBES — 285

PLACING THE SUBSTRATE IN THE CHAMBER — 290

INTRODUCING PROCESS GAS INTO THE CHAMBER THROUGH THE PROCESS GAS INJECTOR — 295

FIG. 5